# EUROPEAN PATENT SPECIFICATION

(11) **EP 0 729 068 B1**
(45) Date of publication and mention of the grant of the patent: **05.07.2000**
(21) Application number: 96107091.9
(22) Date of filing: 16.04.1991
(51) Int. Cl.: G03F 7/004, H05K 3/18

(54) **Photosensitive resin composition and method of forming conductive pattern**
Fotoempfindliche Harzzusammensetzung und Verfahren zur Herstellung eines leitfähigen Musters
Composition à base de résine photosensible et procédé de fabrication d'un motif conducteur

(30) Priority: 20.04.1990 JP 10301890; 18.05.1990 JP 12664090; 19.09.1990 JP 24720390
(43) Date of publication of application: 28.08.1996
(62) Divisional of application: 91303374.2
(73) Proprietor: NISSHINBO INDUSTRIES, INC., Chuo-ku ,Tokyo (JP)
(72) Inventor: Suzuki, Toshio, c/o Nisshinbo Ind., Inc., Adachi-ku, Tokyo (JP); Marutsuka, Toshinori, c/o Nisshinbo Ind., Inc., Adachi-ku, Tokyo (JP)
(74) Representative: Stuart, Ian Alexander

(56) References cited:
- EP-A- 0 130 615
- EP-A- 0 347 114

## Description

This application has been divided out of application 91303374.2 which discloses and claims a method of forming an electrically conductive pattern by means of a photosensitive resin composition consisting of a resin and a metal salt or complex dissolved in a common solvent. The present invention relates to a photosensitive resin composition for forming electrically conductive patterns and to a method for using the photosensitive resin composition to form such patterns, wherein the composition comprises reduced metal colloid particles dispersed in a photosensitive resin.

The conductive patterns formed by the invention are used as printed circuits, electrodes and heating elements.

Typical of the conventional methods for forming conductive patterns are (1) the pattern printing process using conductive paste, (2) the subtractive process in which the conductive pattern is formed by etching a copper-plated laminate to remove nonpattern regions, and (3) the additive process in which a plating resist pattern (negative) is formed on a substrate and the remaining portions are selectively plated.

Among the shortcomings of method (1) are that the conductivity of the pattern, the adhesive strength of the paste and the pattern precision are low while the production cost is high. As relates to application of the method in the printed circuit field, moreover, it is not practical from the point of through-hole continuity and the fact that the paste exhibits low soldering heat resistance.

Method (2) has problems in that the process is complex, fine pattern features are difficult to form and the plating adhesion at through-hole portions is less than satisfactory. What is more, the method has already matured to the point where further substantial improvements cannot be expected.

Method (3) was developed to eliminate waste arising from the removal of nonpattern portions by etching and to respond to demands for higher wiring density and reliability. However, since the catalyst-containing resin layer that the plating is applied to is not patterned, its electrical insulation property is poor. Further, the method does not enable easy formation of fine patterns, the catalyst contained in the substrate further impairs the insulation property, the strength and other physical properties are inferior, the cost of catalyst is high, the plating adherence is low, and roughening is required prior to plating.

Preferred embodiments of the present invention provide an improvement of the aforesaid additive method which enables an increase in plating adhesion without need for roughening, simplification of the pattern forming process, and improvement of pattern precision.

The present invention provides a photosensitive resin composition formed by dispersing reduced metal colloid particles in a photosensitive resin and a method of forming electrically conductive patterns in which the photosensitive resin composition is applied in a prescribed pattern to a substrate, the patterned substrate is pre-baked and then successively subjected to exposure, development and post-baking, and electroless plating is conducted on the result.

The substrate used in the present invention is selected on the basis of the intended application and is not particularly limited. Examples of usable substrates are copper-plated laminated sheet, metal sheet, plastic sheet, plastic film and ceramic sheet.

Generally the metal colloid particles used for preparing the photosensitive resin composition are disposed in a solvent. The photosensitive resin should then be soluble in the solvent. It has to have affinity for the reduced metal colloid particles. Insofar as it meets these requirements, however, it can be of any kind or type (negative or positive type). It can be any of the photosensitive resins in general use, among which there can be specifically mentioned photosensitive polyimide and novolac resin, cyclized natural rubber, cyclized synthetic rubber, polyvinylcinnamate, polymethylisopropenylketone, polyvinylphenol, polyvinyl-p-azidobenzoate, polymethacryloyloxybenzalacetophenone, and polyvinylalcohol, to which has been added a photosensitive agent.

The reduced metal colloid particles dispersed in the photosensitive resin act as an electroless plating catalyst and enhance the plating adherence.

It is preferable to use reduced metal colloid particles which exhibit high plating catalytic activity and good dispersability in the photosensitive resin. They should also preferably exhibit good stability with respect to atmospheric air and moisture. As specific examples of reduced metal colloids that can be used in the invention there can be mentioned those set out in Japanese Unexamined Patent Public Disclosure No. 1(1989)-315334, specifically such Group VIII elements of the Periodic Table as iron, cobalt, nickel, rhodium and palladium. It is also possible to use such Group Ib elements of the same table as gold, silver and copper. These metals can be used singly or in combinations of two or more.

While the ratio between the amount of the reduced metal colloid particles and the amount of the photosensitive resin used can be varied widely in accordance with the physical properties required of the film on which plating is carried out, the type of reduced metal colloid particles used and other factors, it is preferable to use 5 - 100 parts by weight of the reduced metal colloid particles per 100 parts by weight of the photosensitive resin.

Where metals falling in Group VIII of the Periodic Table are used, the reduced metal colloid particles can be produced by the method disclosed in the aforesaid Japanese Unexamined Patent Public Disclosure No.1(1989)-315334, namely by reduction of a metallic salt in a mixed solvent consisting of a lower alcohol and an aprotic polar compound. The same method can also be used for Group Ib metals.

Typical lower alcohols that can be used include methanol and ethanol, while typical aprotic polar compounds for use in the invention include such amide compounds as formamide and dimethylformamide.

The mixed solvent preferably contains 200 - 0.01 part by weight of the aprotic polar compound per 100 parts by weight of the lower alcohol.

As usable metallic salts there can be mentioned sulfates, nitrates, chlorides and organic salts (e.g. acetates).

The metallic salt is reduced by adding a reducing agent to the solution containing the metallic salt. As the reducing agent there can be used NaBH₄, KBH₄, LiBH₄, (CH₃)₂NBH₃, formaldehyde, stannous chloride, and sodium hypophosphite. The reducing agent is added as a 0.1 - 5 wt% solution in the aforesaid lower alcohol, aprotic polar compound or mixed solvent prepared from these.

The reducing agent is preferably added in such an amount as to obtain a reducing electrochemical equivalent equal to 0.5 - 10 times that of the reduction electrochemical equivalent of the metal to be reduced.

A reduction temperature of 10 - 30 °C is generally preferable. Although it is not absolutely necessary to stir the solution during the reduction reaction, it is better to do so since stirring enhances the reaction uniformity. Low-speed stirring suffices. The aforesaid operations result in the production of a very highly stable colloid dispersion liquid within several seconds to several tens of minutes.

The use of reduce metal colloid particles ensures not only the very fine dispersion of metal particles in the photosensitive resin but also excellent reduction efficiency. As a result, even an applied film of a dry thickness of a mere 0.5 - 5 µ is able to provide a top-rate surface for electroless plating and to ensure strong plating adherence.

For dispersing the reduced metal colloid particles in the photosensitive resin it suffices first to dissolve the photosensitive resin in a solvent consisting of one or more of, for example, chloroform, methylene chloride, trichloroethylene, tetrachloroethylene, benzene, toluene, xylene, acetone, ethyl acetate, dimethylformamide, dimethylsulfoxide, dimethylacetamide and N-methylpyrrolidone and then to mix the resulting resin solution with the aforesaid colloid dispersion liquid.

The amount of solvent used with respect to the amount of photosensitive resin is selected so as to obtain an appropriate viscosity and fluidity and to make the solution appropriate for application to the substrate to be plated.

The photosensitive resin composition is applied to the surface of a substrate of the desired shape and then pre-baked to obtain an applied film containing reduced metal colloid particles. The application of the composition can be carried out by brush, spraying, dipping or other conventional method selected in view of the shape of the substrate.

The conditions (temperature, time) for film formation are determined based on the type and concentration of the photosensitive resin, the film thickness and the like. The nonvolatile content of the solution is normally 0.5 - 10 wt%.

After the film has been formed, it is tightly covered with a mask (negative or positive film) and exposed to light. The amount of exposure at this time can be appropriately adjusted in accordance with the intended purpose of the conductive pattern being formed, based on a prescribed standard amount of exposure required for patterning with the photosensitive resin composition used.

After exposure to light, the film is patterned by development using a developing solution specific for the film.

Ordinarily the developed pattern is post-baked (cured) and directly subjected to an electroless plating process for forming a conductive pattern of a prescribed metal. Alternatively, however, the post-baked pattern can, if necessary, be activated prior to electroless plating by immersion in a bath consisting of a warm aqueous solution of sodium hypophosphite. The electroless plating is conducted by a conventional method selected in view of the intended use of the conductive pattern. Ni plating and Cu plating are typical examples.

The adhesive strength, hardness and plating catalytic activity of the film pattern for plating can be regulated in response to the circumstances by appropriate selection of the type of photosensitive resin and reduced metal colloid particles used, and also by controlling the patterning conditions (exposure, development), the activating treatment conditions and other such operating conditions.

The invention will now be explained with reference to specific examples.

### EXAMPLES

### Reference Example 1 (preparing of reduced metal colloid liquid).

500 g of a metallic salt solution was prepared by dissolving 2.5 g of nickel acetate (tetrahydrate) in a solution (497.5 g) obtained by mixing 100 g of dimethylformamide and 397.5 g of ethanol. Separately, a reducing liquid (500 g) was prepared by dissolving 0.8 g of sodium borohydride in ethanol. The reducing liquid was dripped into the metallic salt solution under stirring, whereby there was obtained a black metal colloid dispersion liquid.

When sealed in an air atmosphere and left to stand for two months at room temperature, this colloid dispersion liquid exhibited excellent stability and, specifically, neither experienced any coagulation or precipitation nor suffered any degradation in activity.

### Example 1 .

The reduced metal colloid liquid prepared in Reference Example 1 was diluted with N-methyl-2-pyrrolidone (NMP) and then dispersed in a negative type photosensitive polyimide (Lithocoat PI-400, product of Ube Industries, Ltd.) such that the amount of nickel acetate became 25 PHR, whereby there was obtained a mixed dispersion liquid with a resin concentration of 1 wt%.

A coat of the mixed solution was applied to the surface of a substrate film of Sunever B410 (polyimide varnish, product of Nissan Chemical Industries, Ltd.) formed on a glass plate and the result was pre-baked (dried) at 65 °C for 2 hour. After pre-baking, the applied film (thickness: 5µ) was directly covered with a stainless steel mask and exposed to ultraviolet light from a mercury lamp at an exposure rate of 1 J/cm².

The exposed film was then subjected to pattern formation by immersion in a developing solution (organic solvent type, 25°C) specific for the photosensitive resin film for 3 minutes, whereafter it was rinsed for 1 minute each in specified solutions (first stage rinsing in an ethanol solution containing 5% N-methyl-2-pyrrolidone; second stage rinsing in ethanol).

The resulting pattern was heat treated at 160 °C for 30 minutes and at 230 °C for 30 minutes and immersed in a 50 °C Ni plating solution (Sumer S680, product of Japan Kanigen Co. Ltd.) for 5 minutes.

Gradual deposition of nickel started about 20 seconds after immersion in the plating solution and an electrically conductive pattern exhibiting metallic luster was obtained after 5 minutes. The surface resistivity of the conductive portion was 80 Ω and the masked portion exhibited insulating property. The adherence and pattern precision of the conductive pattern were good.

### Example 2

A pattern obtained in the same manner as in Example 1 was first activated by immersion in a 5% sodium hypophosphite solution at 50 °C for 1 minute and then immersed in the same Ni plating solution for 3 minutes. About 3 seconds after immersion, nickel began to deposit simultaneously over the entire pattern surface and a conductive pattern like that in Example 1 was obtained after 3 minutes. The surface resistivity of the conductive portion was 7 Ω and the masked portion exhibited insulating property. The adherence and pattern precision of the conductive pattern were good.

### Example 3

An activated pattern for plating obtained according to Example 2 was immersed in Enplate Cu-408 copper plating solution (product of Japan Meltex Inc.) at room temperature for 3 minutes. Deposition of copper started about 4 seconds after immersion and an electrically conductive pattern exhibiting coppery luster was obtained after 3 minutes. The surface resistivity of the conductive portion was 0.8 Ω and the masked portion exhibited insulating property. The adherence and pattern precision of the conductive pattern were good.

### Example 4

A mask (negative film) produced by Toppan Printing Co., Ltd. was directly applied to the surface of a pre-baked film obtained according to Example 1 and then overlaid with a Pyrex glass plate. The result was exposed to light from a metal halide lamp at an -exposure rate of 2 J/cm², immersed in a developing solution specific for the photosensitive resin film for 2 minutes, and subjected to ultrasonic development, whereby there was obtained a pattern. The pattern was then activated and nickel plated under the same conditions as in Example 1 . As a result there was obtained a conductive pattern which had sharp pattern features in the linewidth range upward from 100 µm and also exhibited good conductivity.

The invention makes it possible to obtain a conductive pattern by a simple method. Since the plating is conducted on a photosensitive resin film which contains dispersed reduced metal colloid particles as a plating catalyst, the conductive (plated) layer is not susceptible to the ready exfoliation experienced by conventional electroless plated layers, even though no roughening of the substrate is carried out. As the film application, development and plating processes can be conducted by immersion, there are no restrictions on the shape or size of the substrate to be processed. It is thus possible to form conductive patterns on various types of substrates suitable for specific purposes.

Moreover, since the adhesive strength, hardness, plating catalytic activity and the like of the film pattern for plating can be regulated as suitable for the use to which the conductive pattern is to be put, it becomes possible to provide various types of metal plating. Further, the fact that the plating process can be conducted at a relatively low temperature (10 - 90°C) ensures that there will be little or no adverse effect on the original physical properties of the film.

There is the further advantage that the use of the reduced metal colloid particles eliminates the need for conducting a reduction step during patterning so that a substantial simplification of the patterning process is realized.

## Claims

1. A photosensitive resin composition comprising reduced metal colloid particles dispersed in a photosensitive resin.

2. A photosensitive resin composition according to claim 1 wherein the reduced metal colloid particles are obtained by reducing a salt of a metal selected from Group Ib and Group VIII of the Periodic Table of Elements in a solvent.

3. A method of forming electrically conductive patterns comprising the steps of:
(a) applying a photosensitive resin composition consisting of reduced metal colloid particles dispersed in a photosensitive resin to a surface of a substrate in a prescribed pattern and successively conducting (b) prebaking, (c) exposure to light, (d) development and (e) post-baking, and
electroless plating the result of step (e).

4. A method according to claim 3, wherein the reduced metal colloid particles are obtained by reducing a salt of a metal selected from Group Ib and group VIII of the Periodic Table of Elements in a solvent.

5. A method according to claim 3, wherein the reduced metal colloid particles are obtained by reducing a salt of a metal selected from Group Ib and Group VIII of the Periodic Table of Elements in a mixed solvent consisting of a lower alcohol and an aprotic polar compound.

## Patentansprüche

1. Lichtempfindliche Harzzusammensetzung, die in einem lichtempfindlichen Harz dispergierte durch Reduzieren erhaltene kolloide Metallteilchen umfasst.

2. Lichtempfindliche Harzzusammensetzung nach Anspruch 1, worin die durch Reduzieren erhaltene kolloide Metallteilchen durch Reduzieren eines Salzes eines aus der Gruppe Ib und der Gruppe VIII des Periodensystems der Elemente ausgewählten Metalls in einem Lösungsmittel erhalten wurden.

3. Verfahren zum Ausbilden elektrisch leitender Muster, folgende Schritte umfassend:
(a) das Aufbringen einer lichtempfindlichen Harzzusammensetzung, die aus in einem lichtempfindlichen Harz dispergierten durch Reduzieren erhaltene kolloide Metallteilchen besteht, auf eine Oberfläche eines Substrats in einem vorgeschriebenen Muster und die anschließende Durchführung von (b) Vorhärtung, (c) Belichtung, (d) Entwicklung und (e) Nachhärtung, sowie
chemisches Plattieren des Resultats von Schritt (e).

4. Verfahren nach Anspruch 3, worin die durch Reduzieren erhaltene kolloide Metallteilchen durch Reduzieren eines Salzes eines aus Gruppe Ib und Gruppe VIII des Periodensystems der Elemente ausgewählten Metalls in einem Lösungsmittel erhalten werden.

5. Verfahren nach Anspruch 3, worin die durch Reduzieren erhaltene kolloide Metallteilchen durch Reduzieren eines Salzes eines aus Gruppe Ib und Gruppe VIII des Periodensystems der Elemente ausgewählten Metalls in einem Lösungsmittelgemisch erhalten werden, das aus einem niederen Alkohol und einer aprotischen polaren Verbindung besteht.

## Revendications

1. Une composition à base de résine photosensible comprenant des particules colloïdales de métal réduit dispersées dans une résine photosensible.

2. Une composition à base de résine photosensible selon la revendication 1 dans laquelle les particules colloïdales de métal réduit sont obtenues par réduction d'un sel d'un métal choisi parmi le Groupe Ib et le Groupe VIII du Tableau Périodique des Eléments dans un solvant.

3. Un procédé de fabrication de motifs électriquement conducteurs comprenant les étapes consistant à :
(a) appliquer une composition à base de résine photosensible se composant de particules colloïdales de métal réduit dispersées dans une résine photosensible sur la surface d'un substrat selon un motif prescrit et effectuer successivement (b) une pré-cuisson, (c) une exposition à la lumière, (d) un développement et (e) une post-cuisson, et
revêtir par plaquage auto-catalytique le produit résultant de l'étape (e).

4. Un procédé selon la revendication 3, dans lequel les particules colloïdales de métal réduit sont obtenues par réduction d'un sel d'un métal choisi parmi le Groupe Ib et le Groupe VIII du Tableau Périodique des Eléments dans un solvant.

5. Un procédé selon la revendication 3, dans lequel les particules colloïdales de métal réduit sont obtenues par réduction d'un sel d'un métal choisi parmi le Groupe Ib et le Groupe VIII du Tableau Périodique des Eléments dans un solvant mixte se composant d'un alcool inférieur et d'un composé polaire aprotique.
